(19) Europäisches Patentamt

European Patent Office

Office européen des brevets

(11) **EP 4 375 691 A1**

(12) **EUROPEAN PATENT APPLICATION**

(43) Date of publication:
**29.05.2024 Bulletin 2024/22**

(21) Application number: **22208712.4**

(22) Date of filing: **22.11.2022**

(51) International Patent Classification (IPC):
**G01R 33/56** (2006.01)    **G01R 33/561** (2006.01)

(52) Cooperative Patent Classification (CPC):
**G01R 33/5608; G01R 33/561**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(71) Applicant: **Koninklijke Philips N.V.**
**5656 AG Eindhoven (NL)**

(72) Inventors:
• **MEINEKE, Jan Jakob**
  **Eindhoven (NL)**

• **CABALLERO JIMENEZ, Jose Maria**
  **Eindhoven (NL)**
• **DONEVA, Mariya Ivanova**
  **5656AG Eindhoven (NL)**
• **SCHUELKE, Christophe Michael Jean**
  **5656AG Eindhoven (NL)**

(74) Representative: **Philips Intellectual Property & Standards**
  **High Tech Campus 52**
  **5656 AG Eindhoven (NL)**

(54)    **APPARATUS FOR RECONSTRUCTING A MAGNETIC RESONANCE IMAGE BASED ON A SUBSPACE-SAMPLING OPERATOR**

(57)    The invention refer to an apparatus (130) for reconstructing a MR image and/or parameter map based on a MR time domain signal. A providing unit (133) provides a time domain signal acquired in time domain MRI utilizing a sampling pattern in k-space and a magnetic resonance acquisition sequence. A providing unit (132) provides a subspace-sampling operator that provides for a given k-space location of the sampling pattern temporal subsamples of basis vectors of a compression subspace.

The compression subspace is utilizable for compressing the time domain signal. A processing unit (133) processes the time domain signal utilizing the subspace-sampling operator. A reconstruction unit (134) reconstructs the MR image and/or parameter map based on the processed time domain signal. This allows for a more accurate and less computationally resource intensive reconstruction of MR images and/or parameter maps in the context of time domain magnetic resonance imaging.

FIG. 4

EP 4 375 691 A1

**Description**

FIELD OF THE INVENTION

The invention relates to an apparatus, a method and a computer program product for reconstructing a magnetic resonance image and/or parameter map based on a magnetic resonance time domain signal acquired in a time domain magnetic resonance imaging. Further, the invention refers to a system for reconstructing a magnetic resonance image and/or parameter map utilizing the apparatus, method and/or computer program product above. Moreover, the invention refers to a sequence determination apparatus for determining an acquisition sequence for acquiring a magnetic resonance time domain signal in a time domain magnetic resonance imaging and to an acquisition sequence determined accordingly.

BACKGROUND OF THE INVENTION

Time domain magnetic resonance imaging allows to not only provided a qualitative analysis of the imaged object, but also the quantitative analysis leading, for instance, to the possibility to determine actual tissue types imaged. However, in a time domain magnetic resonance imaging a huge amount of data is generated and has to be analyzed, for instance, utilizing magnetic resonance fingerprinting. Thus, although time domain magnetic resonance imaging provides many advantages, it is computationally demanding. Moreover, during the acquisition there is no time to spatially encode each time-point of the measurement such that a heavy spatial subsampling is generally used. This leads to an increased reconstruction complexity. Thus, compression algorithms have been developed that allow to reconstruct magnetic resonance images or parameter maps in a compression subspace allowing for a decrease in the usage of computational resources, in particular, storage and calculation resources. Moreover, these compression algorithms allow for a regularization of the reconstruction problem such that also strongly undersampled measurements can be reconstructed. However, even when utilizing a compression subspace the calculations are still complex and computational resource intensive and thus difficult to use, for instance, in applications where the results have to be provided as fast as possible to a medical practitioner, e.g. in emergency situations. Moreover, the compression can introduce noise or make, in particular, the fingerprinting algorithm that is often utilized for generating the magnetic resonance images and/or parameter maps less accurate. Moreover, the accuracy and/or noise, if compression is utilized, can strongly depend on the utilized magnetic resonance acquisition sequence, wherein it is often difficult or nearly impossible to determine or predict an optimal, i.e. less noise causing, acquisition sequence for a compression algorithm before the actual acquisition.
It would thus be advantageous if it were possible to allow for a more accurate and at the same time computationally less resource intensive reconstruction of magnetic resonance images and/or parameter maps based on time domain magnetic resonance imaging. Moreover, it would be advantageous if magnetic resonance acquisition sequences could be determined in a context of utilizing a compression reconstruction algorithm that allow for a more accurate reconstruction of the magnetic resonance images and/or parameter maps in this context.

SUMMARY OF THE INVENTION

It is an object of the present invention to provide an apparatus, a method and a computer program product that allow for a more accurate and less computationally resource intensive reconstruction of magnetic resonance images and/or parameter maps in the context of time domain magnetic resonance imaging. Moreover, it is a further object of the invention to provide an apparatus, method and computer program product that allow in this context to provide a magnetic resonance acquisition sequence that allows for an even more accurate reconstruction of the magnetic resonance images and/or parameter maps.
In a first aspect of the invention an apparatus for reconstructing a magnetic resonance image and/or parameter map based on a magnetic resonance time domain signal acquired in a time domain magnetic resonance imaging is presented, wherein the apparatus comprises a) a time domain signal providing unit for providing a time domain signal acquired in time domain magnetic resonance imaging utilizing a predetermined sampling pattern in k-space and a predetermined magnetic resonance acquisition sequence, b) an operator providing unit for providing a subspace-sampling operator that provides for a given k-space location of the sampling pattern temporal subsamples of basis vectors of a compression subspace, wherein the compression subspace is utilizable for compressing the time domain signal, c) a signal processing unit for processing the time domain signal utilizing the subspace-sampling operator, and d) a reconstruction unit for reconstructing the magnetic resonance image and/or parameter map based on the processed time domain signal.
Since the subspace-sampling operator is provided such that it provides for a given k-space location of the sampling pattern temporal subsamples of basis vectors of a compression subspace that can be utilized for compressing the time domain signal, and since the time domain signal is processed utilizing the subspace-sampling operator, the magnetic resonance images and/or parameter maps can be reconstructed based on the processed time domain signal utilizing compression algorithms more directly, for instance, without iteration steps and also more accurately. Moreover, since the subspace-sampling operator is directly provided, i.e. can be calculated before the acquisition of the time domain signal, it is possible to utilize the subspace-sampling operator for optimizing the magnetic resonance acquisition sequence such that a magnetic resonance acquisition sequence can be determined based on the subspace-sampling operator that allows for an even more accurate reconstruction of the magnetic resonance images and/or parameter maps.

Generally, the apparatus is configured for reconstructing a magnetic resonance image and/or a parameter map. The apparatus can be realized in any form of hardware and/or software provided by a general or dedicated computer system. In particular, the apparatus can also be realized in distributed computing, for example, can be realized as part of a computer network in which the functions of the apparatus are provided by different processors, servers or computer systems. A magnetic resonance image can refer to any known magnetic resonance image that is utilized in commonly known magnetic resonance imaging. For example, a magnetic resonance image can refer to a T1, T2 weighted image, a gradient echo-based image, an inversion recovery-based image, a diffusion weighted image, a perfusion weighted image, etc. Parametric maps can in this context be a result of a quantitative analysis of a magnetic resonance signal and can refer to, for example, any kind of tissue map, but also to diffusion parameters, kinetic parameters, proton density, magnetization transfer saturation, longitudinal and effective transverse relaxation rates, etc. In the context of the invention, the magnetic resonance time domain signal is acquired in a time domain magnetic resonance imaging. A time domain magnetic resonance imaging is characterized by the possibility to resolve transient dynamics of the magnetization, in particular, the signal is not necessarily measured in a steady state as is typically the case with magnetic resonance signal measurements. An example for time domain magnetic resonance imaging can be found in the article "Magnetic resonance fingerprinting", D. Ma et al., Nature, Vol. 495, 187-192 (2013).

The time domain signal providing unit is configured for providing a time domain signal. Generally, the time domain signal providing unit can refer to a storage unit or can be communicatively coupled to a storage unit, wherein the time domain signal is already stored on the storage unit and the time domain signal providing unit is configured for providing the signal stored on the storage unit. Further, the time domain signal providing unit can also be a receiving unit for receiving the time domain signal, for instance, from an input unit or via an interface directly from a magnetic resonance imaging apparatus, and for providing the received time domain signal. The time domain signal is acquired in a time domain magnetic resonance imaging utilizing the predetermined sampling pattern in k-space and a predetermined magnetic resonance acquisition sequence. For acquiring a time domain signal, different patterns in k-space are commonly utilized and known. Generally, the predetermined sampling pattern can refer to any pattern in k-space. However, preferably the sampling pattern refers to a spiral or radial sampling pattern with interleaves. In this context, the k-space is a spatial frequency domain into which the magnetic resonance measurements can directly be mapped. The predetermined magnetic resonance acquisition sequence refers to a particular setting of pulse sequences and pulsed field gradients that is utilized for acquiring the time domain signal. Preferably, a balanced gradient-echo or a spoiled gradient-echo acquisition sequence is utilized. However, also spin-echo sequences can be used.

The operator providing unit is configured for providing a subspace-sampling operator. The operator providing unit can be a storage unit or can be communicatively coupled with the storage unit on which the subspace-sampling operator is already stored and is then configured for providing the same. Moreover, the operator providing unit can also be an input unit or can be communicatively coupled to an input unit for receiving the subspace-sampling operator, for instance, from a user, and is then configured for providing the received subspace-sampling operator. Generally, the subspace-sampling operator provides for a given k-space location of the sampling pattern temporal subsamples of basis vectors of a compression subspace. Thus, the subspace-sampling operator depends on the utilized predetermined sampling pattern in k-space and the compression subspace that is utilizable for compressing the time domain signal and is generally also predetermined. Generally, the compression subspace refers to a subspace into which a time domain signal can be compressed, for instance, by mapping the time domain signal into the compression subspace, wherein the compression subspace is defined by respective basis vectors. The temporal subsample of a basis vector defines for respective time points of the time domain signal associated subsamples of the basis vectors. The subspace-sampling operator is preferably provided such that it provides for each k-space location of the sampling pattern the respective temporal subsamples of the basis vectors. Moreover, since in most cases different sampling patterns are utilized for acquiring a time domain signal, the subspace-sampling operator can comprise for the respective k-space locations of the different sampling patterns the respective temporal subsamples of basis vectors of the respective compression subspace. Generally, the subspace-sampling operator can be predetermined, in particular, before the measurement of the time domain signal based on a chosen, i.e. predetermined, sampling pattern and based on a chosen, i.e. predetermined, compression subspace. In a preferred embodiment, the providing of the subspace-sampling operator comprises generating the subspace-sampling operator as a combination of a selection operator associated with the sampling pattern in k-space and a decompression operator comprising the basis vectors of the compression subspace utilizable for compressing a signal into the compression subspace. Generally, the selection operator is associated with a sampling pattern in k-space, in particular, depends on the sampling pattern in k-space. For example, the selection operator provides a mapping between the sampling pattern in k-space and the measured time domain signal and thus provides a mapping for each measurement at a respective time point of the measured time domain signal into the respective point in k-space defined by the sampling pattern in k-space. Preferably, the selection operator further indicates that all values of the k-space not belonging to the sampling pattern in k-space are set to zero. The decompression operator generally comprises the basis vectors of a compression subspace into which a signal can be mapped for compression. Preferably, the decompression operator is a linear matrix that provides an orthogonal temporal basis for the compression subspace. In particular, it is preferred that the decompression operator and thus also the compression subspace are determined utilizing a singular value decomposition, for instance, of a matching dictionary utilized in a fingerprinting matching algorithm. However, also other compression subspaces and thus other decompression operators based on other compression algorithms can be utilized. For example, compression subspaces determined utilizing machine learning algorithms, like a latent space of an auto-decoder algorithms, or utilizing independent component analysis can also be utilized. The combination of the selection operator and the decompression operator is preferably a matrix multiplication, in which the selection operator is applied to the decompression operator.

The signal processing unit is configured for processing the time domain signal utilizing the subspace-sampling operator. The construction unit is then configured for reconstructing the magnetic resonance image and/or parameter map based on the processed time domain signal. Generally, the processing of the time domain signal depends on the algorithm utilized by the reconstruction unit for reconstructing the magnetic resonance image and/or parameter map based on the processed time domain signal. In particular, a subspace-sampling operator is in most cases directly applied to the time domain signal in order to determine the processed time domain signal. Moreover, the processing can also comprise further processing steps, for example, for preparing the time domain signal before processing the time domain signal. For reconstructing the magnetic resonance image and/or parameter map based on the processed time domain signal, respective known algorithms, in particular, compression algorithms, can be utilized. In particular, a fingerprinting algorithm can be used in which the processed time domain signal is utilized for determining a matching signal which is then compared in a matching process with a library of characteristic signals, for instance, of respective tissue samples to determine a magnetic resonance image and/or parameter map. However, also other reconstruction algorithms like machine learning algorithms based on the processed time domain signal, iterative algorithms based on the processed time domain signal, etc. can be utilized for reconstructing the magnetic resonance image and/or parameter map.

In a preferred embodiment, the processing of the time domain signal comprises calculating

$$\hat{x} = E^H (SV)^+ wy$$

wherein $\hat{x}$ is the processed time domain signal, y the measured time domain signal in k-space, w comprises the density compensation weights, $(SV)^+$ the pseudo-inverse of the subspace-sampling operator and $E^H$ the Hermitian of an encoding operator comprising an fast Fourier transform operator for transforming a signal in k-space into a signal in image space and optionally a gridding operation for gridding the sampling pattern and a coil-combination operator indicative of coil characteristics of an acquisition magnetic resonance system. In particular, the processed time domain signal is an image signal, i.e. refers to an image associated with the measured time domain signal, and is represented in the compressed domain defined by V. Moreover, the processed time domain signal can in this case also be regarded as a fingerprinting signal, since it can be used for fingerprint matching with a dictionary. The encoding matrix E for non-cartesian image reconstruction refers preferably to $E = GFS$, wherein $G$ is the gridding operator, F the fast Fourier transformation operator and S the operator representing the coil sensitivities. In some embodiments a sampling density compensation w can be added for Cartesian reconstruction, which is a diagonal matrix in non-cartesian k-space, leading to $\hat{x} = E^H (SV)^+ wy$. However, in iterative reconstruction methods w can also be omitted or can be integrated as part of $E$.

This calculation allows to avoid a computational resource intensive iterative determination of the processed time domain signal, wherein the processed time domain signal in this case refers to subsampled images that can be utilized for determining the magnetic resonance image and/or parameter map, for instance, by determining a fingerprint based on the processed time domain signal.

In a preferred embodiment, the processing of the time domain signal is based on the pseudo-inverse of the subspace-sampling operator, wherein the pseudo-inverse of the subspace-sampling operator is determined as a Moore-Penrose pseudo-inverse. Generally, the Moore-Penrose pseudo-inverse can be used for solving equations of the general form $Ax = b$ for x in a least-square sense, wherein $A$ is a rectangular matrix, by calculating $A^+ = (A^H A)^{-1} A^H$. Preferably, $A$ is chosen such that the linear system of equations is overdetermined. In the application of the Moore-Penrose pseudo-inverse to the subspace-sampling operator $A$ is set to the subspace-sampling operator, for instance, to SV. In a preferred embodiment, the reconstructing of the magnetic resonance image and/or parameter map utilizes magnetic resonance fingerprinting, wherein the reconstruction of the magnetic resonance image and/or parameter map is based on the processed time domain signal that is utilized for dictionary matching. An example of a respective fingerprinting algorithm that can be utilized with the processed time domain signal can be found, for instance, in the article "Magnetic resonance fingerprinting", D. Ma et al., Nature, Vol. 495, 187-192 (2013). Preferably, when utilizing the fingerprinting algorithm and performing the dictionary matching, the entries of the dictionary utilized in the dictionary matching are compressed into the compression subspace.

In a preferred embodiment, the apparatus further comprises an acquisition parameter validation unit configured to validate acquisition parameters for the acquisition sequence for acquiring the time domain signal with respect to a matching error based on the subspace-sampling operator. Generally, since the subspace-sampling operator depends on the decompression operator and also on the sampling pattern and can thus be predetermined based on the utilized compression algorithm, the subspace-sampling operator also allows for a prediction of a matching performance of a respective predetermined acquisition sequence. Preferably, the validation is thus performed with respect to a matching error, for instance, represented by an error score. In particular, a lower matching error refers to a better image or parameter map quality.

In a preferred embodiment the acquisition parameter validation unit if further configured for determining an acquisition sequence based on the validation. For example, the apparatus can further comprise a potential acquisition sequences providing unit for providing a plurality of potential acquisition sequences with respective acquisition parameters. The acquisition parameter validation unit can then be adapted to validate each of the plurality of potential acquisition sequences, for instance, by calculating a respective matching error score based on the subsampling operator, and can then determine the potential acquisition sequence as acquisition sequence to be utilized that comprises the lowest matching error.

Preferably an iterative algorithm can be utilized by the acquisition parameter validation unit comprising a) providing a potential acquisition sequence, b) providing a target matching error, c) determining a matching error for the potential acquisition sequence based on the subspace-sampling operator, d) validating the potential acquisition sequence by comparing the determined matching error with the target matching error and d) based on the comparison, i) determine the potential acquisition sequence as the acquisition sequence or ii) provide a new potential acquisition sequence, for instance, by amending one or more acquisition parameters of the potential acquisition sequence.

Preferably, the determination of the matching error for a potential acquisition sequence is determined by the following algorithm by the acquisition parameter validation unit. In a first step a dictionary and a respective compression subspace for compressing the dictionary are determined based on the potential acquisition sequence. Generally, all known methods for determining a dictionary and a respective compression subspace for a predetermined acquisition sequence can be utilized. Further, a sampling pattern to be utilized when acquiring the time domain signal is provided. For example, any of the above already described sampling patterns can be utilized. Then an artificial time domain signal can be generated such that for the artificial time domain signal the exact matching, i.e. the ground-truth parameters, in the dictionary is known. For example, the generated dictionary can be utilized to generate an artificial processed signal based on the signals in the dictionary and the artificial processed signal can be back processed into an associated artificial time domain signal. In particular, a mixing operator can be used for mixing the respective artificial time domain signal to simulate the contributions of a k-space to a processed signal. Moreover, the predetermined sampling pattern can be utilized for generating the artificial time domain signal based on the simulated mixing. Then a predetermined noise pattern can be added to the respective artificial time domain signal to receive a noisy artificial time domain signal. Generally, different predetermined noise patterns can be used, for example, in every determination of the matching error. Further, based on the predetermined sampling pattern and the predetermined compressing subspace the subsampling operator can be generated. Based on the subsampling operator the noisy artificial time domain signal can be processed such that the processed noisy artificial time domain signal can be matched utilizing the dictionary. The respective matching results, for instance, the T1, T2, etc. values, can then be compared with the known matching from which the artificial time domain signal has been generated, i.e. with the ground-truth parameters from which the time domain signal has been generated. Based on the comparison a valuation can be performed. For example, based on the comparison a respective matching error can be determined and the sequence can be validated based on the determined matching error.

In a preferred embodiment, the acquisition parameters are validated based on a condition number of the subspace-sampling operator. Generally, the condition number of an operator determines a noise amplification during an inversion of the operator. In fact, the smaller the condition number the more robust is the reconstruction with respect to noise amplification and the better the image quality of the reconstructed image and/or parameter maps. Moreover, preferably, the subspace-sampling operator and thus the acquisition parameters of the acquisition sequence are determined to minimize the condition number of the subspace-sampling operator. This minimization can be performed in any known optimization algorithm utilizing the condition number as minimization goal and the acquisition parameters, for example, the subsampling, of the acquisition sequence as optimizable variables. However, the condition number can also simply be utilized for selecting from a plurality of possible acquisition sequences the sequence with the lowest condition number for acquiring the respective images.

In a further aspect of the invention a sequence validation apparatus for validating an acquisition sequence for acquiring a magnetic resonance time domain signal in a time domain magnetic resonance imaging is presented, wherein the apparatus comprises a) an acquisition sequence providing unit for providing a potential acquisition sequence comprising respective acquisition parameters and a predetermined sampling pattern, b) an operator providing unit for providing a subspace-sampling operator that provides for a given k-space location of the predetermined sampling pattern temporal subsamples of basis vectors of a compression subspace, wherein the compression subspace is utilizable for compressing a time domain signal acquired utilizing the potential acquisition sequence, and c) an acquisition parameter validation unit for validating the acquisition parameters of the potential acquisition sequence for acquiring the time domain signal with respect to a matching error based on the subspace-sampling operator. Preferably, the apparatus further comprises an acquisition parameter generation unit for generating an acquisition sequence based on the validation of the acquisition parameters of the potential acquisition sequence.

Generally, for this aspect of the invention the same definitions and embodiments as described above with respect to the first aspect of the invention can be applied. In particular, the embodiments described with respect to validating and determining acquisition parameters for the acquisition sequence for acquiring the time domain signal based on the subspace-sampling operator can also be embodiments of this aspect of the invention.

In a further aspect of the invention, a system for reconstructing a magnetic resonance image and/or parameter map based on a magnetic resonance time domain signal acquired in a time domain magnetic resonance imaging, wherein the system comprises a) a magnetic resonance imaging system configured for acquiring a time domain signal in time domain magnetic resonance imaging utilizing a predetermined sampling pattern in k-space and a predetermined magnetic resonance acquisition sequence, and b) an apparatus as described above and/or a sequence determination apparatus as described above.

In a further aspect of the invention, a computer-implemented method for reconstructing a magnetic resonance image and/or parameter map based on a magnetic resonance time domain signal acquired in a time domain magnetic resonance imaging is presented, wherein the method comprises a) providing a time domain signal acquired in time domain magnetic resonance imaging utilizing a predetermined sampling pattern in k-space and a predetermined magnetic resonance acquisition sequence, b) providing a subspace-sampling operator that provides for a given k-space location of the sampling pattern temporal subsamples of basis vectors of a compression subspace, wherein the compression subspace is utilizable for compressing the time domain signal, c) processing the time domain signal utilizing the subspace-sampling operator, and d) reconstructing the magnetic resonance image and/or parameter map based on the processed time domain signal.

In a further aspect of the invention, a computer-implemented sequence validation method for validating an acquisition sequence for acquiring a magnetic resonance time domain signal in a time domain magnetic resonance imaging is presented, wherein the method comprises a) providing a potential acquisition sequence comprising respective acquisition parameters and a predetermined sampling pattern, b) providing a subspace-sampling operator that provides for a given k-space location of the predetermined sampling pattern temporal subsamples of basis vectors of a compression subspace, wherein the compression subspace is utilizable for compressing a time domain signal acquired utilizing the potential acquisition sequence, and c) validating the acquisition parameters of the potential acquisition sequence for acquiring the time domain signal with respect to a matching error based on the subspace-sampling operator.

In a further aspect of the invention, an acquisition sequence for acquiring a magnetic resonance time domain signal in a time domain magnetic resonance imaging determined utilizing a sequence determination apparatus as described above and/or a sequence determination method as described above is presented.

In a further aspect of the invention, a computer program product for reconstructing a magnetic resonance image and/or parameter map based on a magnetic resonance time domain signal acquired in a time domain magnetic resonance imaging, wherein the computer program product causes an apparatus as described above to carry out the method as described above is presented.

In a further aspect of the invention, a computer program product for determining an acquisition sequence for acquiring a magnetic resonance time domain signal in a time domain magnetic resonance imaging, wherein the computer program product causes a sequence determination apparatus as described above to carry out the sequence determination method as described above is presented.

It shall be understood that the apparatuses as described above, the methods as described above, the system as described above, and the computer program products as described above, have similar and/or identical preferred embodiments, in particular, as defined in the dependent claims.

It shall be understood that a preferred embodiment of the present invention can also be any combination of the dependent claims or above embodiments with the respective independent claim.

These and other aspects of the invention will be apparent from and elucidated with reference to the embodiments described hereinafter.

BRIEF DESCRIPTION OF THE DRAWINGS

In the following drawings:

Fig. 1 shows schematically and exemplarily a system for reconstructing magnetic resonance images and/or parameter maps,

Fig. 2 shows schematically and exemplarily a flowchart of a method for reconstructing magnetic resonance images and/or parameter maps,

Fig. 3 shows schematically and exemplarily parameter maps showing the improved reconstruction when utilizing the above system and/or method, and

Fig. 4 shows schematically and exemplarily a visualization of effect of a selection operator on a decompression operator.

DETAILED DESCRIPTION OF EMBODIMENTS

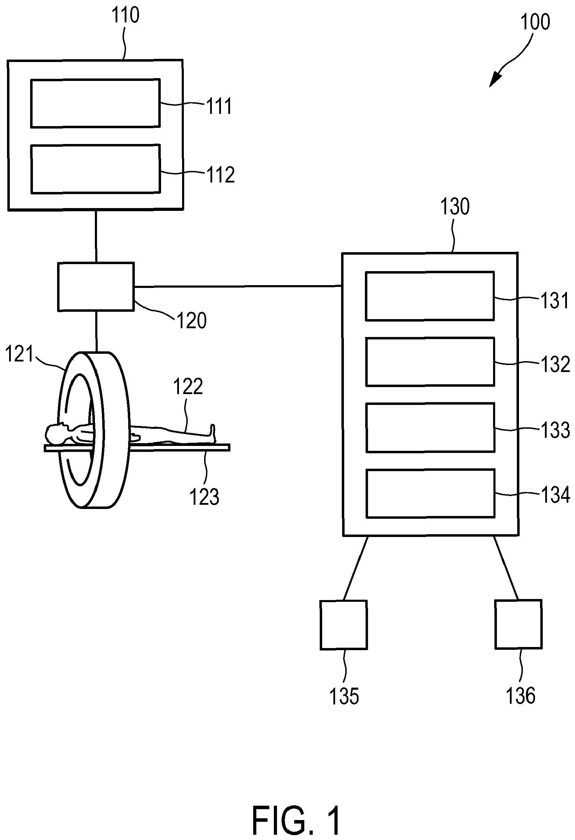

Fig. 1 shows schematically and exemplarily a system for reconstructing a magnetic resonance image and/or parameter map based on a magnetic resonance time domain signal acquired in a time domain magnetic resonance imaging. The system comprises a magnetic resonance imaging system with a magnetic resonance imaging controller 120, and an apparatus 130 for reconstructing the magnetic resonance image and/or parameter map based on the magnetic resonance time domain signal acquired by the magnetic resonance imaging system. Optionally, the system 100 can comprise a sequence determination apparatus 110 for determining an acquisition sequence for acquiring the magnetic resonance time domain signal in the time domain magnetic resonance imaging performed by the magnetic resonance imaging system.

If the sequence determination apparatus is present, it can be utilized for determining an optimized acquisition sequence that can then be utilized by the magnetic resonance imaging controlling unit 120 for acquiring the time domain signal utilizing the magnetic resonance imaging unit 121. The sequence determination apparatus 110 comprises an operator providing unit 111 and an acquisition parameter determination unit 112. The operator providing unit 110 is configured for providing a subspace-sampling operator. For example, the operator providing unit 111 can provide the subspace-sampling operator by accessing a storage unit on which a subspace-sampling operator is already stored or by receiving the subspace-sampling operator, for instance, via an input unit. However, the operator providing unit 111 can also be configured for generating the subspace-sampling operator and for providing the generated subspace-sampling operator. For instance the operation providing unit 111 can be configured for calculating the subspace-sampling operator based on a user input indicating a respective sampling pattern of the magnetic resonance acquisition and based on information on the utilized compression, for instance, information indicative of the decompression operator. The such accessed, received or generated subspace-sampling operator can then be provided for further processing, for instance, to the acquisition parameter determination unit 112. Generally, the subspace-sampling operator provides for a given k-space location of a predetermined sampling pattern utilized in the acquisition of the time domain signal temporal subsamples of basis vectors of a compression subspace. Thus, the subsampling operator can be predetermined based on a given, i.e. predetermined, sampling pattern that should be utilized during the acquisition of the time domain signal and based on a compression subspace that should be utilized when reconstructing the magnetic resonance images based on the time domain signal. The compression subspace is generally utilizable for compressing the time domain signal and can be determined, for instance, utilizing known compression algorithms, in particular, utilizing a single value decomposition. Thus, the subspace-sampling operator that is later utilized in the reconstruction of the magnetic resonance images and/or parameter maps can be predetermined and provided and can then also be utilized for optimizing the acquisition sequence for acquiring the time domain signal as performed by the acquisition parameter determination unit 112. In particular, utilizing the predetermined subspace-sampling operator for determining an acquisition sequence allows to adapt the acquisition sequence optimally to the later performed reconstruction and to optimize the interaction between the acquisition sequence utilized for acquiring the time domain signal and the reconstruction algorithm utilizing the subspace-sampling operator. Further details and examples on how the acquisition parameter determination unit 112 can determine the acquisition parameters based on the subspace-sampling operator will be provided further below.

If the sequence determination apparatus 110 is part of the system 100, the such determined acquisition sequence for acquiring the time domain signal can then be provided to the magnetic resonance imaging controlling unit 120. However, if the sequence determination apparatus 110 is omitted in the system 100, any other known suitable acquisition sequence can be utilized by the magnetic resonance imaging controlling unit 120. The magnetic resonance imaging controlling unit 120 then controls the magnetic resonance unit 121 to acquire time domain signals from patient 122 lying on patient table 123. The such acquired time domain signals can then be provided to apparatus 130 for reconstructing a magnetic resonance image and/or a parameter map from the time domain signal. The apparatus 130 comprises a time domain signal providing unit 131, an operator providing unit 132, a signal processing unit 133 and a reconstruction unit 134. Further, the apparatus 130 can also comprise a display unit 135, for instance, for displaying reconstructed magnetic resonance images and/or parameter maps and/or an input unit 136 that allows a user to interact with the apparatus 130, for example, by providing a mouse, a keyboard, etc. The time domain signal providing unit 131 can in this example be realized, for example, as an interface unit for interfacing with the magnetic resonance imaging controlling unit 120 for receiving the time domain signal from the magnetic resonance imaging controlling unit 120 and providing the same for further processing, for instance, to the signal processing unit 133. However, in other embodiments the time domain signal providing unit 131 can also be configured to access, for example, a storage unit or a network for receiving the time domain signal that is already stored on the storage unit or the network and for providing the respectively accessed time domain signal. Moreover, in other embodiments the time domain signal providing unit can be regarded as comprising the magnetic resonance imaging controlling unit 120 and optionally also the magnetic resonance imaging unit 121 such that the time domain signal providing unit in such an embodiment is configured for directly acquiring the time domain signal and providing the acquired time domain signal. Generally, a time domain signal is acquired utilizing a predetermined sampling pattern in k-space and predetermined magnetic resonance acquisition sequence, in particular, a magnetic resonance acquisition sequence determined by the magnetic resonance acquisition sequence determination unit 110.

The operator providing unit 132 can be similar to the operator providing unit 110 of the magnetic resonance acquisition sequence determination apparatus 110. In particular, the operator providing unit provides a subspace-sampling operator as already described above. If a magnetic resonance acquisition sequence determination apparatus 110 is present in the system 100, the operator providing unit 132 is in particular configured for providing the same subspace-sampling operator that is utilized for determining the acquisition sequence of the time domain signal. Otherwise, a respective subspace-sampling operator can be provided that is based on the respective utilized sampling pattern and the respective to be utilized compression algorithm.

The signal processing unit 133 is then configured for processing the time domain signal utilizing the subspace-sampling operator and the reconstruction unit 134 is configured for reconstructing the magnetic resonance image and/or parameter map based on the processed time domain signal. Further details and preferred examples of the processing of the time domain signal and the reconstruction of the magnetic resonance image and/or parameter map are described below.

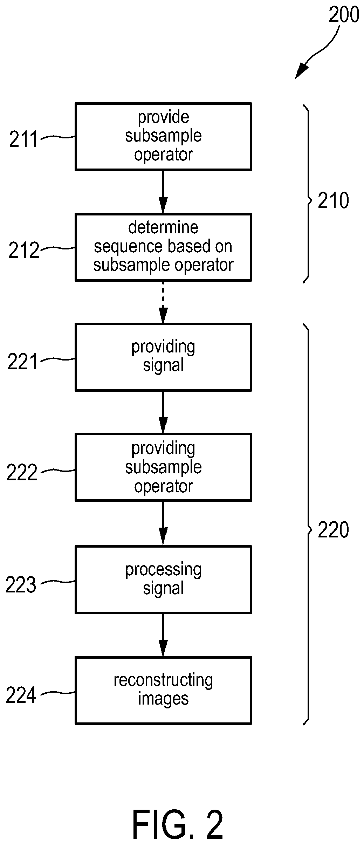

Fig. 2 shows schematically and exemplarily a flow chart of method 200 for reconstructing a magnetic resonance image and/or a parameter map. The method 200 comprises steps 220 for reconstructing a magnetic resonance image and/or parameter map and optionally comprises steps 210 for firstly determining an acquisition sequence for acquiring a magnetic resonance time domain signal in a time domain magnetic resonance imaging based on which the magnetic resonance images and/or parameter maps can then be constructed. If the steps 210 are present in method 200, then in a first step 211 a subspace-sampling operator is provided in accordance with the principles described above, for instance, with respect to Fig. 1. In a step 212, acquisition parameters for the acquisition sequence for acquiring the time domain signal can then be determined based on the subspace-sampling operator. These steps can be performed, for instance, in accordance with the principles described with respect to the sequence determination apparatus 110. The respectively determined acquisition parameters can then be provided to a magnetic resonance imaging system for acquiring the respective time domain signal, wherein these steps are not shown in Fig. 2. The steps 220 then comprise in a first step 221 providing a time domain signal acquired in time domain magnetic resonance imaging utilizing a predetermined sampling pattern in k-space and, for instance, the above determined magnetic resonance acquisition sequence. In a step 222, a subspace-sampling operator is provided, wherein, if the steps 210 are present, the same subspace-sampling operator as utilized for determining the magnetic resonance acquisition sequence is provided. In step 223, the time domain signal is processed utilizing the subspace-sampling operator and in step 224, the magnetic resonance image and/or parameter map is reconstructed based on the processed time domain signal. Generally, the steps 220 can be performed, for instance, by the apparatus 130 as described with respect to Fig. 1.

In the following, details and preferred embodiments will be described. In a preferred example, the magnetic resonance image and/or parameter map is reconstructed utilizing magnetic resonance fingerprinting. Generally, a performance of a dictionary matching in magnetic resonance fingerprinting is difficult to analyze comprehensively due to the complex interplay of, object-dependent, spatial subsampling artifacts with the encoding power of the sequence. While computational runtime can be significantly reduced when using compressed matching, the choice of the dimensionality of the compression subspace remains in most cases ad-hoc. Going towards shorter acquisition sequences in order to decrease the acquisition time, degraded performance is observed. This degraded performance can often only be compensated by sophisticated reconstruction methods, which lead to a significant computational overhead and unclear convergence properties.

Utilizing a subspace-sampling operator as described above allows to clarify the interplay of magnetic resonance acquisition sequence, acquisition schedule, e.g. number of interleaves, acquisition order, etc., optimal dimension of subspace and noise amplification for, in particular, compressed, dictionary matching. At the same time, the utilizing of the subspace-sampling operator allows to achieve the optimal possible estimation of coefficients with respect to the chosen compression basis in closed-form. Also, it becomes possible to automatically chose the optimal dimensionality of the compression subspace, given a target noise-performance. In particular, the noise-performance depends on the condition number of the subspace-sampling operator. Thus, since the subspace-sampling operator depends on the compression space, for instance, via the decompression operator determining the compression subspace, the compression subspace and thus also its dimensionality can be optimized with respect to leading to a low compression number of the subspace-sampling operator. For this optimization any known direct or indirect optimization algorithm can be utilized. Generally, the invention is based on the insight that the decompression operator in form of the subspace-sampling operator can, under reasonable assumptions, be explicitly inverted. This avoids the need for iterative methods during magnetic resonance fingerprinting reconstructions for more challenging sequences, e.g. shorter sequences.

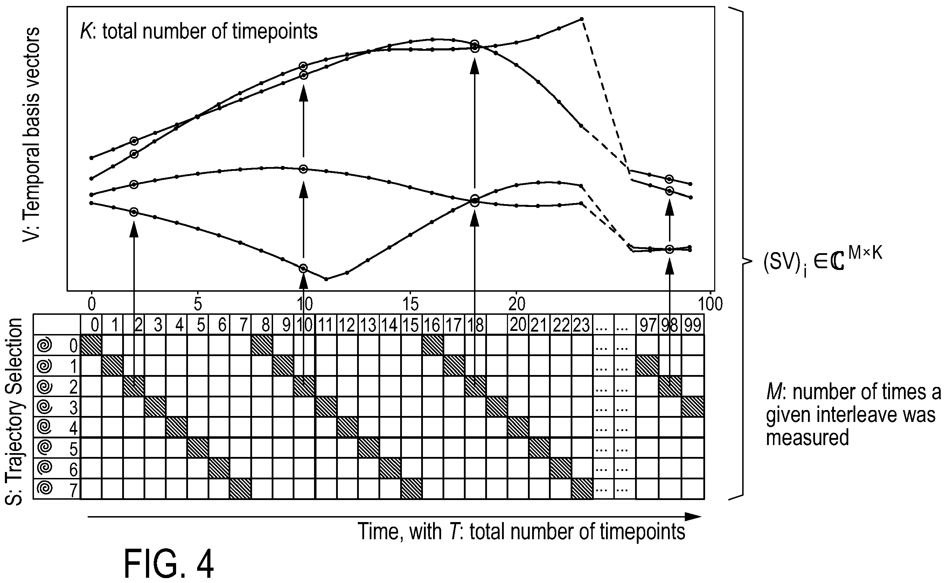

As a starting point, in most reconstruction algorithms the following least squares problem is to be solved

$$\|SVE\hat{x} - y\|_2^2$$

wherein $\hat{x}$ is the processed time domain signal, i.e. in this embodiment the compressed fingerprinting signal, y the time domain signal, $SV$ the subspace-sampling operator generated by the selection operator S and the decompression operator V for each location in k-space, and E the encoding operator comprising a fast Fourier transform (FFT) operator for transforming a signal in k-space into a signal in image space and optionally a gridding operation for gridding the sampling pattern and a coil-combination operator indicative of coil characteristics of an acquisition magnetic resonance system. Generally the solution is constrained to lie in the compression subspace spanned by the basis vectors provided by the decompression operator V. The decompression operator $V$ can be obtained, for example, via single value decomposition from a full dictionary D used in a fingerprinting reconstruction algorithm according to $U\Sigma V^H = D$. An example of the effect of the selection operator S on the decompression operator V to form the subspace-sampling operator if shown schematically and exemplarily in Fig. 4. The upper part of the schema shows a representation of an example of temporal basis vectors for the compression subspace as are represented by the decompression operator V . The lower part of the schema shows a representation of the selection operator for different measurements of an interleaf, i.e. for different sampling patterns. The arrows indicate the selection, i.e. subsampling, of the temporal basis vectors as an effect of the selection operator working on the decompression operator. As schematically shown in Fig. 4 the subspace-sampling operator provides for a given k-space location of the sampling pattern temporal subsamples of temporal basis vectors of the compression subspace. However, it is noted here that Fig. 4 only provides an exemplary and graphic visualization of the mathematical effects of the two operators and does not exactly represent the mathematical results, i.e. the subspace-sampling operator.

A widely used method to accelerated convergence in iterative methods is to employ a preconditioner which approximately inverts the system matrix, $SVE$ in this case, so that the eigenvalues are clustered around 1 as much as possible. Concretely, a matrix M is introduced with the property $MSV \approx Id,$ which leads to

$$\|M^{-1}MSVE\hat{x} - y\|_2^2 \rightarrow \|MSVE\hat{x} - My\|_2^2$$

The subspace-sampling operator has the advantage that it can be inverted exactly such that a new problem can be obtained leading to a linear equation that can be easily calculated:

$$\|E\hat{x} - My\|_2^2 \rightarrow E^H E\hat{x} = E^H My$$

Which can be solved directly using gridding with sampling density compensation w:

$$\hat{x} = E^H(SV)^+wy$$

Wherein the sampling density compensation w can be omitted, if an iterative approach for solving the above problem is utilized. Generally, in this case the formulation is similar to utilizing a conjugate gradient scheme for solving a SENSE problem, when the encoding operator includes a, optionally non-uniform, FFT and coil-sensitivities. As a consequence, the above formulation can also be applied with additional spatial undersampling. For example, encoding a smaller field of view in a spiral acquisition leads to fewer measured interleaves, and therefore a higher sampling rate on the time-evolution. This in turn leads to better conditioning of $SV$ and thus also of $M.$

Given the above direct method to compute the conditioning of M using $SV$ also gives a simple method to assess the performance of a magnetic resonance acquisition sequence based only the temporal sampling rate, which can be used to optimize acquisition sequences. This is in stark contrast to previous methods shown in the literature, which rely on simulating the full data acquisition and reconstruction process, which includes assumptions about the imaged object and considerable computational overhead. This is orthogonal to sequence optimization methods based on the Cramer-Rao-Lower-Bound, which are mainly concerned with the "encoding power" of the sequence without consideration of the acquisition. In particular, as is shown below the optimization of the acquisition sequence can be based on a condition number of *SV*. Generally, the pseudo-inverse can be computed as the Moore-Penrose pseudo-inverse, which has one of the following expressions depending on the shape of *V* :

$$(SV)^+ = (SV)^H (SV(SV)^H)^{-1}$$

Or

$$(SV)^+ = ((SV)^H SV)^{-1} (SV)^H$$

The singular values of $(SV)^+$ determine the condition number of the problem, and therefore directly the noise-propagation properties. If a singular value approaches zero, this means the problem becomes ill-posed, necessitating a change in magnetic resonance acquisition sequence, acquisition scheme, e.g. use fewer interleaves, or reducing the subspace dimension at the possible cost of information loss. Moreover, since the condition number is directly indicative for the noise propagation during the calculation of the inverse and since the lower the condition number the better the inversion accuracy, an optimization algorithm can be utilized for optimizing acquisition parameters with respect to leading to a low condition number, i.e. a minimization of the condition number can be utilized for determining an optimal acquisition sequence.

Based on the above the magnetic resonance images and/or parameter maps can then be reconstructed using, for instance, magnetic resonance fingerprinting. Generally, in magnetic resonance fingerprinting dictionary matching is performed. This dictionary matching is usually achieved by maximizing the inner product in coefficient space between dictionary entries $\hat{s}$ and, in particular, normalized, processed time domain signals $\hat{x}$.

$$\operatorname*{argmax}_{s} \|\langle \hat{s}(r) | \hat{x}(r) \rangle\| = \operatorname*{argmax}_{s} \|\langle V^H s(r) | V^H x(r) \rangle\| \simeq \operatorname*{argmax}_{s} \|\langle s(r) | x(r) \rangle\|$$

The 'hat' signifies that the signals have been compressed into a low-dimensional compression subspace spanned by the basis vectors provided by the decompression operator V, wherein the decompression operator can be obtained as already described above by a single value decomposition of the complete dictionary D. Generally an uncompressed fingerprinting signal x is reconstructed from the undersampled time domain signal y, using the encoding operator $E^H$, which for spiral acquisitions consists of the gridding, FFT and coil-combination. The selection operator $S^H$ couples the timepoint on a magnetic resonance time domain signal with the acquired k-space position, essentially embedding the undersampled k-space by zero-filling, w performs density-compensation for non-cartesian trajectory. This leads to

$$x = E^H S^H w y$$

Introducing the compression, this is then modified to

$$\hat{x} = V^H E^H S^H w y = E^H V^H S^H w y$$

This latter step works, because $V^H$ operates in the time-domain whereas $E^H$ in the spatial domain, and thus the subspace-sampling operator $V^H S^H$, or equivalently $SV$ can be introduced. Note that this operator is defined per k-space location, in the case of spiral acquisitions, per interleave.

The action of S on V is to temporally subsample the basis vectors of the compression subspace. These remaining subsampled representative time signals are no longer guaranteed to be orthogonal. In this case, the Hermitian conjugate is not a useful approximation of the matrix inverse. Rather, the above equation can be approximated with the above already determined equation

$$\hat{x} = E^H (SV)^+ w y$$

Thus the fingerprinting signal can be easily calculated utilizing the subspace-sampling operator without iteration and then utilized in dictionary matching.

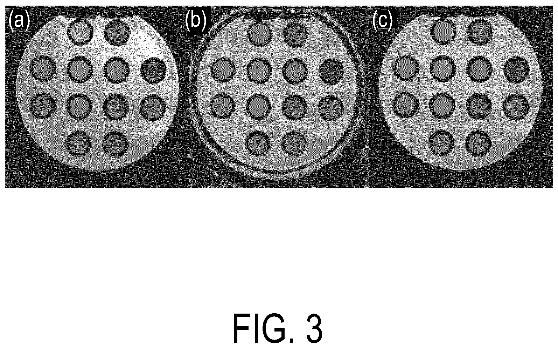

Fig. 3 shows T2 matching results illustrating the effect of the proposed method. In particular, the T2 map (a) on the left is obtained using standard dictionary matching without utilizing the subspace-sampling operator. The T2 map (b) in the middle is reconstructed utilizing dictionary matching after a reconstruction of the fingerprinting signal utilizing the time domain signal processed with the subspace-sampling operator according to the above equation. T2 map (c) on the right is reconstructed utilizing an iterative approach without the subspace-sampling operator, in particular, utilizing five Conjugate-Gradient iterations for determining the fingerprinting signal. The noise in the background of panel (b) is due to different thresholding. Images (b) and (c) are almost identical and show a high quality and low noise.

In a preferred embodiment, the subspace-sampling operator is further used for validation and optionally also determining an acquisition sequence as is described in the following. In particular, it is preferred that the acquisition sequence is validated and determined with respect to an expected matching performance, for instance, with respect to an expected matching error. The matching performance, in particular, the matching error, is given by the accuracy and precision with which the matching can be performed and thus the parameters, like T1, T2, etc. can be determined. Generally, the matching error for magnetic resonance fingerprinting can depend on an encoding power of an acquisition sequence, i.e. the possibility of the sequence to measure the respective parameters, the sampling pattern, in particular, the spatial undersampling of the sampling pattern, and an intrinsic signal-to-noise ratio of the measurement and the reconstruction algorithm utilized. For fully sampled sampling patterns a sequence encoding power, and thus the suitability of a sequence for a specific matching can be easily determined, utilizing, for instance, Cramer-Rao-Bound. However, previous attempts to include effects of spatial undersampling were either limited to very specific applications or computationally very resource intensive. The present invention allows to overcome these drawbacks be utilizing the undersampling operator as described above for a fast and computationally inexpensive calculation of respective fingerprinting signals, for instance, via the processed time domain signal. In particular, with this approach the effects of undersampling in the sampling pattern can be included into the sequence validation and determination in a simple, trajectory- and object-independent way.

A detailed example of a preferred algorithm for validating and then determining an acquisition sequence is described below. This algorithm can be performed by a respective dedicated or general computing system, in particular, by a respective sequence validation apparatus that is configured to perform this method utilizing respective computation units. Firstly a respective potential acquisition sequence is provided. For example, one or more of such potential sequences can be already stored on a respective storage, or can be received via an input unit from a user. Based on the potential acquisition sequence a dictionary $D$, and compressed temporal subspace $V$ can then be computed. Further a sampling pattern, in particular, a subsampling pattern, e.g. a spiral acquisition with 10 interleaves, can be chosen, for instance, via an input from a user or can also be predetermined. Next an artificial time domain signal is determined for which the matching parameters, like, T1, T2, etc. are already known as ground truth parameters. For example, a random selection of fingerprinting signals s can be generated from the already generated dictionary with predetermined matching parameters. Preferably, the fingerprint signals are non-normalized signals and provided thus correct relative amplitudes. Then a random unitary matrix M can be utilized for mixing the fingerprinting signals such that aspects of the fingerprinting signals are spatially distributed in order to simulate the mixing of the signals normally found in k-space. However, the random unitary matrix can be completely different from the encoding found in k-space. This has the advantage that a matrix can be chosen that is easy to handle computationally. Optionally, of course also a respective encoding matrix that represents the encoding in k-space can be utilized. Thus, the matrix can refer to a fast Fourier transformation, which would lead to a simulated k-space, but this would impose a certain structural interpretation, which is unnecessary for the working of the algorithm. The respectively mixed signals $m = Ms$ can then be computed. A complex iid Gaussian noise can then be added to the mixed signal to simulate the noise expected in a measured time domain signal. Also for generating the artificial time domain signal the sampling pattern, in particular the subsampling is added, e.g. be selecting for each interleaf / the respective measured time points. The noise can also be added after the application of the subsampling. Moreover, the subspace-sampling operator can also be determined based on the decompression operator and the respective sample pattern. Then based on the determined artificial time domain signal and the subspace-sampling operator the artificial fingerprinting signal can be determined. For example, first coefficients c can be computed by applying a pseudo-inverted subsampling operator to the artificial time domain signal and then further applying the hermitian of the mixing operator M. Based on the artificial fingerprinting signal a compressed matching for the matching parameters can then be performed to get, for instance, T1, T2, etc. estimates. Based on a comparison between the known matching parameters and the estimated matching parameters evaluate errors, i.e. a matching error, can be determined. Based on this matching error an optimization can be performed. For example, a minimization of the error based on acquisition sequence can be performed. Alternatively, a target matching error can be provided and the matching error can be compared with this target for finding a sequence that fulfills this target. Generally, it can be expected for most cases that the optimization landscape is very complex with many local minima. However, in most cases it is not necessary to find the absolute minima and the minimization can be regarded as successful also if a local minimum is found. Generally, for the optimization algorithms like simulated annealing, genetic algorithms, or gradient-descent algorithms can be utilized. Preferably, multiple types of optimization algorithms with variable starting points are applied if an absolute minimum is to be found. However, it is expected that in most cases many minima are similar in performance, and that is does not matter to find the global minimum. Moreover, using a low-dimensional parametrization, e.g. via spline interpolation to reduce the number of optimization parameters, i.e. the acquisition sequence, can be advantageous. Generally, hyperparameters for optimization that can be utilized to prime the optimization can include the number of example tissue parameter combinations to evaluate on, the size of subspace, i.e. the number of coefficients, the range of T1/T2 to optimize for relative weighting of T1/T2 errors.

Although the above examples, mainly referred to reconstruction methods utilizing matching, the subspace-sampling operator can also be utilized in any other reconstruction method utilizing subspaces, i.e. compression, and are influences by the specific sampling pattern, for example, T2-shuffling.

Other variations to the disclosed embodiments can be understood and effected by those skilled in the art in practicing the claimed invention, from a study of the drawings, the disclosure, and the appended claims.

In the claims, the word "comprising" does not exclude other elements or steps, and the indefinite article "a" or "an" does not exclude a plurality.

A single unit or device may fulfill the functions of several items recited in the claims. The mere fact that certain measures are recited in mutually different dependent claims does not indicate that a combination of these measures cannot be used to advantage.

Procedures like the processing of the detection signals for measuring the medical parameter, the authentication, the control of the medical monitoring system, et cetera, performed by one or several units or devices can be performed by any other number of units or devices. These procedures, particularly the control of the medical monitoring system in accordance with the control method carried out by the medical monitoring system controller, can be implemented as program code means of a computer program and/or as dedicated hardware.

A computer program may be stored/distributed on a suitable medium, such as an optical storage medium or a solid-state medium, supplied together with or as part of other hardware, but may also be distributed in other forms, such as via the Internet or other wired or wireless telecommunication systems.

Any reference signs in the claims should not be construed as limiting the scope.

The invention refer to an apparatus for reconstructing a MR image and/or parameter map based on a MR time domain signal. A providing unit provides a time domain signal acquired in time domain MRI utilizing a sampling pattern in k-space and a magnetic resonance acquisition sequence. A providing unit provides a subspace-sampling operator that provides for a given k-space location of the sampling pattern temporal subsamples of basis vectors of a compression subspace. The compression subspace is utilizable for compressing the time domain signal. A processing unit processes the time domain signal utilizing the subspace-sampling operator. A reconstruction unit reconstructs the MR image and/or parameter map based on the processed time domain signal. This allows for a more accurate and less computationally resource intensive reconstruction of MR images and/or parameter maps in the context of time domain magnetic resonance imaging.

**Claims**

1. An apparatus for reconstructing a magnetic resonance image and/or parameter map based on a magnetic resonance time domain signal acquired in a time domain magnetic resonance imaging, wherein the apparatus (130) comprises:

   a time domain signal providing unit (131) for providing a time domain signal acquired in time domain magnetic resonance imaging utilizing a predetermined sampling pattern in k-space and a predetermined magnetic resonance acquisition sequence,
   an operator providing unit (132) for providing a subspace-sampling operator that provides for a given k-space location of the sampling pattern temporal subsamples of basis vectors of a compression subspace, wherein the compression subspace is utilizable for compressing the time domain signal,
   a signal processing unit (133) for processing the time domain signal utilizing the subspace-sampling operator, and
   a reconstruction unit (134) for reconstructing the magnetic resonance image and/or parameter map based on the processed time domain signal.

2. The apparatus according to claim 1, wherein the providing of the subspace-sampling operator comprises generating the subspace-sampling operator as a combination of a selection operator associated with the sampling pattern in k-space and a decompression operator comprising the basis vectors of the compression subspace utilizable for compressing a signal into the compression subspace.

3. The apparatus according to any of claims 1 and 2, wherein the processing of the time domain signal comprises calculating

$$\hat{x} = E^H (SV)^+ wy$$

wherein $\hat{x}$ is the processed time domain signal, y the measured time domain signal in non-cartesian k-space, w comprises the density compensation weights, $(SV)^+$ the pseudo-inverse of the subspace-sampling operator and $E^H$ the Hermitian of an encoding operator comprising, a fast Fourier transform operator for transforming a signal in k-space into a signal in image space and optionally a gridding operation for gridding the sampling pattern and a coil-combination operator indicative of coil characteristics of an acquisition magnetic resonance system.

4. The apparatus according to any of the preceding claims, wherein the processing of the time domain signal is based on the pseudo-inverse of the subspace-sampling operator, wherein the pseudo-inverse of the subspace-sampling operator is determined as a Moore-Penrose pseudo-inverse.

5. The apparatus according to any of the preceding claims, wherein the reconstructing of the magnetic resonance image and/or parameter map utilizes magnetic resonance fingerprinting, wherein the reconstruction of the magnetic resonance image and/or parameter map is based on the processed time domain signal that is utilized for dictionary matching.

6. The apparatus according to any of the preceding claims, wherein the apparatus (130) further comprises an acquisition parameter validation unit configured to validate acquisition parameters for the acquisition sequence for acquiring the time domain signal with respect to a matching error based on the subspace-sampling operator.

7. The apparatus according to claim 6, wherein the acquisition parameters are validated based on a condition number of the subspace-sampling operator.

8. A sequence validation apparatus for validating an acquisition sequence for acquiring a magnetic resonance time domain signal in a time domain magnetic resonance imaging, wherein the apparatus (110) comprises:

an acquisition sequence providing unit for providing a potential acquisition sequence comprising respective acquisition parameters and a predetermined sampling pattern,
an operator providing unit (111) for providing a subspace-sampling operator that provides for a given k-space location of the predetermined sampling pattern temporal subsamples of basis vectors of a compression subspace, wherein the compression subspace is utilizable for compressing a time domain signal acquired utilizing the potential acquisition sequence, and
an acquisition parameter validation unit (112) for validating the acquisition parameters of the potential acquisition sequence for acquiring the time domain signal with respect to a matching error based on the subspace-sampling operator.

9. The sequence validation apparatus according to claim 8, wherein the apparatus further comprises an acquisition parameter generation unit for generating an acquisition sequence based on the validation of the acquisition parameters of the potential acquisition sequence.

10. A system for reconstructing a magnetic resonance image and/or parameter map based on a magnetic resonance time domain signal acquired in a time domain magnetic resonance imaging, wherein the system (100) comprises:

a magnetic resonance imaging system (121) configured for acquiring a time domain signal in time domain magnetic resonance imaging utilizing a predetermined sampling pattern in k-space and a predetermined magnetic resonance acquisition sequence, and
an apparatus (130) according to any of claims 1 to 7 and/or a sequence validation apparatus (110) according to any of claims 8 to 9.

11. A computer-implemented method for reconstructing a magnetic resonance image and/or parameter map based on a magnetic resonance time domain signal acquired in a time domain magnetic resonance imaging, wherein the method (220) comprises:

providing (221) a time domain signal acquired in time domain magnetic resonance imaging utilizing a predetermined sampling pattern in k-space and a predetermined magnetic resonance acquisition sequence,
providing (222) a subspace-sampling operator that provides for a given k-space location of the sampling pattern temporal subsamples of basis vectors of a compression subspace, wherein the compression subspace is utilizable for compressing the time domain signal,

processing (223) the time domain signal utilizing the subspace-sampling operator, and

reconstructing (224) the magnetic resonance image and/or parameter map based on the processed time domain signal.

12. A computer-implemented sequence validation method for validating an acquisition sequence for acquiring a magnetic resonance time domain signal in a time domain magnetic resonance imaging, wherein the method (210) comprises:

providing a potential acquisition sequence comprising respective acquisition parameters and a predetermined sampling pattern,

providing (211) a subspace-sampling operator that provides for a given k-space location of the predetermined sampling pattern temporal subsamples of basis vectors of a compression subspace, wherein the compression subspace is utilizable for compressing a time domain signal acquired utilizing the potential acquisition sequence, and

validating (212) the acquisition parameters of the potential acquisition sequence for acquiring the time domain signal with respect to a matching error based on the subspace-sampling operator.

13. An acquisition sequence for acquiring a magnetic resonance time domain signal in a time domain magnetic resonance imaging determined utilizing a sequence validation apparatus according to claim 8.

14. A computer program product for reconstructing a magnetic resonance image and/or parameter map based on a magnetic resonance time domain signal acquired in a time domain magnetic resonance imaging, wherein the computer program product causes an apparatus (130) according to any of claims 1 to 7 to carry out the method according to claim 11.

15. A computer program product for determining an acquisition sequence for acquiring a magnetic resonance time domain signal in a time domain magnetic resonance imaging, wherein the computer program product causes an apparatus according to claim 8 to carry out the method according to claim 12.

FIG. 1

200

| 211 | provide subsample operator |
| 212 | determine sequence based on subsample operator |

210

| 221 | providing signal |
| 222 | providing subsample operator |
| 223 | processing signal |
| 224 | reconstructing images |

220

# FIG. 2

# FIG. 3

FIG. 4

**EUROPEAN SEARCH REPORT**

Europäisches Patentamt
European Patent Office
Office européen des brevets

Application Number

EP 22 20 8712

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | SIMON ARBERET ET AL: "GFB-MRF: A parallel spatial and Bloch manifold regularized iterative reconstruction method for MR Fingerprinting", ARXIV.ORG, CORNELL UNIVERSITY LIBRARY, 201 OLIN LIBRARY CORNELL UNIVERSITY ITHACA, NY 14853, 16 October 2020 (2020-10-16), XP081789682, | 1,2,5,6, 8-15 | INV. G01R33/56 G01R33/561 |
| A | * Abstract * <br> * section "2. Method" * <br> * section "4. Discussion" * <br> ----- | 3,4,7 | |
| X | JAKOB ASSLÄNDER ET AL: "Low rank alternating direction method of multipliers reconstruction for MR fingerprinting : Low Rank ADMM Reconstruction", MAGNETIC RESONANCE IN MEDICINE, vol. 79, no. 1, 5 March 2017 (2017-03-05), pages 83-96, XP055736965, US ISSN: 0740-3194, DOI: 10.1002/mrm.26639 | 13 | |
| A | * section "THEORY" * <br><br> ----- | 1-12,14, 15 | TECHNICAL FIELDS SEARCHED (IPC) <br> G01R |
| X | DI CUI ET AL: "Iterative MR Fingerprinting Reconstruction in a Compressed k-space", PROCEEDINGS OF THE 2021 ISMRM & SMRT ANNUAL MEETING & EXHIBITION, 15-20 MAY 2021, ISMRM, 2030 ADDISON STREET, 7TH FLOOR, BERKELEY, CA 94704 USA, no. 1549, 30 April 2021 (2021-04-30), XP040723568, | 13 | |
| A | * the whole document * <br><br> ----- <br> -/-- | 1-12,14, 15 | |

The present search report has been drawn up for all claims

| Place of search | Date of completion of the search | Examiner |
|---|---|---|
| Munich | 13 April 2023 | Durst, Markus |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

Europäisches
Patentamt

European
Patent Office

Office européen
des brevets

**EUROPEAN SEARCH REPORT**

Application Number

EP 22 20 8712

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2019/094322 A1 (BRAUN CHRISTIAN ALEXANDER [DE] ET AL) 28 March 2019 (2019-03-28) | 13 | |
| A | * figure 1 * <br> * paragraph [0018] – paragraph [0081] * <br> ----- | 1-12,14, 15 | |
| X | DEBRA F. MCGIVNEY ET AL: "Magnetic resonance fingerprinting review part 2: Technique and directions", JOURNAL OF MAGNETIC RESONANCE IMAGING, 25 July 2019 (2019-07-25), XP055663708, US ISSN: 1053-1807, DOI: 10.1002/jmri.26877 | 13 | |
| A | * the whole document * <br> ----- | 1-12,14, 15 | |

TECHNICAL FIELDS
SEARCHED     (IPC)

The present search report has been drawn up for all claims

| Place of search | Date of completion of the search | Examiner |
|---|---|---|
| Munich | 13 April 2023 | Durst, Markus |

EPO FORM 1503 03.82 (P04C01)

## ANNEX TO THE EUROPEAN SEARCH REPORT
## ON EUROPEAN PATENT APPLICATION NO.

EP 22 20 8712

This annex lists the patent family members relating to the patent documents cited in the above-mentioned European search report.
The members are as contained in the European Patent Office EDP file on
The European Patent Office is in no way liable for these particulars which are merely given for the purpose of information.

13-04-2023

| Patent document cited in search report | Publication date | Patent family member(s) | Publication date |
|---|---|---|---|
| US 2019094322 A1 | 28-03-2019 | NONE | |

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- **D. MA et al.** Magnetic resonance fingerprinting. *Nature,* 2013, vol. 495, 187-192